# EUROPEAN PATENT SPECIFICATION

(11) **EP 3 029 742 B1**
(45) Date of publication and mention of the grant of the patent: **15.01.2020**
(21) Application number: 14832898.2
(22) Date of filing: 01.08.2014
(51) Int. Cl.: H01L 31/032

(54) **METAL CHALCOGENIDE NANOPARTICLES FOR PREPARING LIGHT ABSORPTION LAYER OF SOLAR CELL, AND PREPARATION METHOD THEREFOR**
METALLCHALCOGENIDNANOPARTIKEL ZUR HERSTELLUNG EINER LEICHTEN ABSORPTIONSSCHICHT EINER SOLARZELLE UND HERSTELLUNGSVERFAHREN DAFÜR
NANOPARTICULES DE CHALCOGÉNURE MÉTALLIQUE POUR PRÉPARER UNE COUCHE D'ABSORPTION DE LUMIÈRE DE CELLULE SOLAIRE ET LEUR PROCÉDÉ DE PRÉPARATION

(30) Priority: 01.08.2013 KR 20130091778; 01.08.2013 KR 20130091781
(43) Date of publication of application: 08.06.2016
(73) Proprietor: LG Chem, Ltd., Yeongdeungpo-gu Seoul 150-721 (KR)
(72) Inventor: YOON, Seokhee, Daejeon 305-380 (KR); PARK, Eun Ju, Daejeon 305-380 (KR); LEE, Hosub, Daejeon 305-380 (KR); YOON, Seokhyun, Daejeon 305-380 (KR)
(74) Representative: Hoffmann Eitle
(86) International application number: PCT/KR2014/007090
(87) International publication number: WO 2015/016649

(56) References cited:
- WO-A1-2012/037276
- WO-A2-2011/065994
- CN-A- 103 055 774
- US-A1- 2012 100 660
- US-A1- 2012 138 866
- US-A1- 2012 282 721
- US-A1- 2013 125 988
- JONGPIL PARK ET AL: "Syntheses of Cu2SnS3 and Cu2ZnSnS4 nanoparticles with tunable Zn/Sn ratios under multibubble sonoluminescence conditions", DALTON TRANSACTIONS: THE INTERNATIONAL JOURNAL FOR INORGANIC, ORGANOMETALLIC AND BIOINORGANIC CHEMISTRY, vol. 42, no. 29, 22 May 2013 (2013-05-22), page 10545, XP055343743, GB ISSN: 1477-9226, DOI: 10.1039/c3dt50849h
- SHI ET AL: "ZnS micro-spheres and flowers: Chemically controlled synthesis and template use in fabricating MS(shell)/ZnS(core) and MS (M=Pb, Cu) hollow microspheres", JOURNAL OF ALLOYS AND COMPOUNDS, ELSEVIER SEQUOIA, LAUSANNE, CH, vol. 441, no. 1-2, 14 June 2007 (2007-06-14), pages 337-343, XP022116794, ISSN: 0925-8388
- JIAGUO YU ET AL: "Ion-Exchange Synthesis and Enhanced Visible-Light Photoactivity of CuS/ZnS Nanocomposite Hollow Spheres", JOURNAL OF PHYSICAL CHEMISTRY C, vol. 114, no. 32, 19 August 2010 (2010-08-19), pages 13642-13649, XP055327144, US ISSN: 1932-7447, DOI: 10.1021/jp101816c

## Description

### [TECHNICAL FIELD]

The present invention relates to metal chalcogenide nanoparticles for manufacturing solar cell light absorption layers and a method of manufacturing the same.

### [BACKGROUND ART]

Solar cells have been manufactured using a light absorption layer formed at high cost and silicon (Si) as a semiconductor material since an early stage of development. To more economically manufacture commercially viable solar cells, structures of thin film solar cells, using an inexpensive light absorbing material such as copper indium gallium sulfo (di) selenide (CIGS) or Cu(In, Ga)(S, Se)₂, have been developed. Such CIGS-based solar cells typically include a rear electrode layer, an n-type junction part, and a p-type light absorption layer. Solar cells including such CIGS layers have a power conversion efficiency of greater than 19%. However, in spite of potential for CIGS-based thin film solar cells, costs and insufficient supply of In are main obstacles to widespread commercial application of thin film solar cells using CIGS-based light absorption layers. Thus, there is an urgent need to develop solar cells using In-free or low-cost universal elements.

Accordingly, as an alternative to the CIGS-based light absorption layer, CZTS(Cu₂ZnSn(S,Se)₄)-based solar cells including copper (Cu), zinc (Zn), tin (Sn), sulfur (S), or selenium (Se), which are extremely cheap elements, have recently received attention. CZTS has a direct band gap of about 1.0 eV to about 1.5 eV and an absorption coefficient of 10⁴ cm⁻¹ or more, reserves thereof are relatively high, and CZTS uses Sn and Zn, which are inexpensive.

In 1996, CZTS hetero-junction PV batteries were reported for the first time, but CZTS-based solar cells have been less advanced than CIGS-based solar cells and photoelectric efficiency of CZTS-based solar cells is 10% or less, much lower than that of CIGS-based solar cells. Thin films of CZTS are manufactured by sputtering, hybrid sputtering, pulsed laser deposition, spray pyrolysis, electro-deposition/thermal sulfurization, e-beam processing, Cu/Zn/Sn/thermal sulfurization, and a sol-gel method.

Meanwhile, PCT/US/2010-035792 having publication number WO 2011/065994 A2 discloses formation of a thin film through heat treatment of ink including CZTS/Se nanoparticles on a base. Generally, when a CZTS thin film is formed with CZTS/Se nanoparticles, it is difficult to enlarge crystal size at a forming process of a thin film due to previously formed small crystals. In addition, when each grain is small, interfaces are extended and thereby electron loss occurs at interfaces, and, accordingly, efficiency is deteriorated. Furthermore, to enlarge grain size using CZTS/Se nanoparticles, extremely long heat treatment period is required and thereby it is extremely inefficient in terms of cost and time.

Thus, it is preferable to use nanoparticles, which are used in thin films, including Cu, Zn and Sn, and precursor type particles, which may be changed to CZTS/Se during a thin film process, instead of CZTS/Se crystals for grain growth and shortening of process time. As the precursor, metal nanoparticles or binary compound particles consisting of a metal element and Group VI element may be used. However, when a mixture of metal nanoparticles are used or the binary compound is used, the particles or element is not mixed homogenously and sufficiently in an ink composition and thereby the metal nanoparticles may be easily oxidized, and, accordingly, it is difficult to obtain a CZTS/Se thin film of superior quality.

Therefore, there is a high need to develop a technology for manufacture of thin film solar cells, which are stable against oxidation and drawbacks of which are minimized due to a homogenous composition, including highly efficient light absorption layers.

### [DISCLOSURE]

### [TECHNICAL PROBLEM]

Therefore, the present invention has been made to solve the above problems and other technical problems that have yet to be resolved.

As a result of a variety of intensive studies and various experiments, the inventors of the present invention developed metal chalcogenide nanoparticles according to claim 1 or claim 3 and confirmed that, when a thin film was manufactured using the metal chalcogenide nanoparticles, the thin film has an entirely uniform composition and are stable against oxidation by adding S or Se to the nanoparticles. In addition, the inventors confirmed that, when a thin film was manufactured further including metal nanoparticles, particle volumes were extended, due to a Group VI element, at a selenization process and thereby light absorption layers having high density grew, and, accordingly, the amount of a Group VI element in a final thin film was increased, resulting in a superior quality thin film and thus completing the present invention.

### [TECHNICAL SOLUTION]

In accordance with one aspect of the present invention, provided are metal chalcogenide nanoparticles according to claim 1 or claim 3.

The term "chalcogenide" of the present invention means a material including a Group VI element, for example, sulfur (S) and/or selenium (Se). As one embodiment, the copper (Cu)-containing chalcogenide may be CuₓS (0.5≤x≤2.0) and/or Cu_{y}Se (0.5≤y≤2.0), the zinc (Zn)-containing chalcogenide may be ZnS and/or ZnSe, and the tin (Sn)-containing chalcogenide may be Sn_{z}S (0.5≤z≤2.0) and/or Sn_{w}Se (0.5≤w≤2.0) and may be at least one selected from the group consisting of, for example, SnS, SnS₂, SnSe and SnSe₂.

The metal chalcogenide nanoparticles may include two phases or three phases. These phases are uniformly distributed in one metal chalcogenide nano particle.

Here, the metal chalcogenide nanoparticles according to the present invention are manufactured by a substitution reaction using reduction potential differences of zinc (Zn), tin (Sn) and copper (Cu) and, as such, metal ingredients to substitute and metal ingredients to be substituted may be uniformly present in the metal chalcogenide nanoparticles.

In the metal chalcogenide nanoparticles including the second phase and third phase according to claim 1, a content ratio of copper and tin may be freely controlled in a range of 0<Cu/Sn by controlling the equivalence ratio of a copper (Cu) salt based on the molar ratio of tin-containing chalcogenide and reaction conditions during substitution reaction. A content ratio of tin and zinc in nanoparticles including the first phase and the second phase according to claim 1 also may be freely controlled in a range of 0<Sn/Zn.

Similarly, when the metal chalcogenide nanoparticles include the first phase, the second phase and the third phase, a composition ratio of zinc, tin, and copper also may be freely controlled by controlling the equivalence ratios of a tin (Sn) salt and copper (Cu) salt based on the initial molar ratio of the zinc-containing chalcogenide. However, when considering formation of a CZTS/Se thin film, a composition ratio of zinc, tin, and copper is preferably in a range of 0.5≤Cu/(Zn+Sn)≤1.5 and 0.5≤Zn/Sn≤2, more preferably in a range of 0.7≤Cu/(Zn+Sn)≤1.2 and 0.8≤Zn/Sn≤1.4.

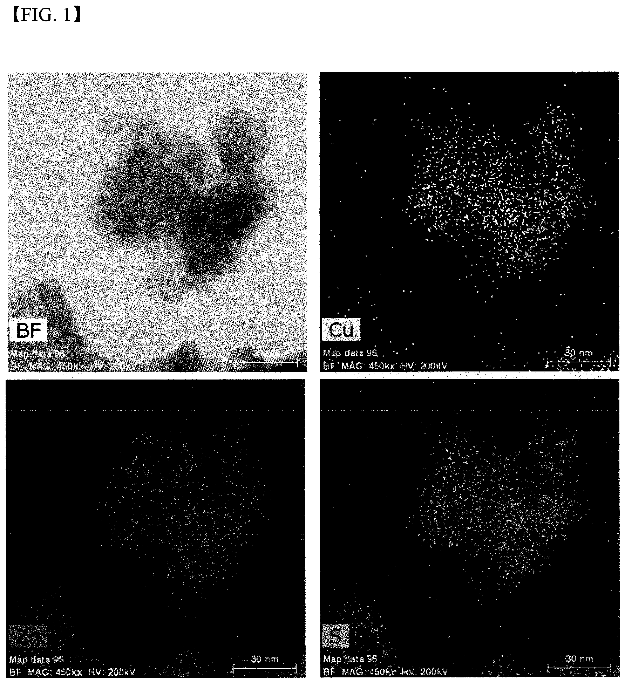

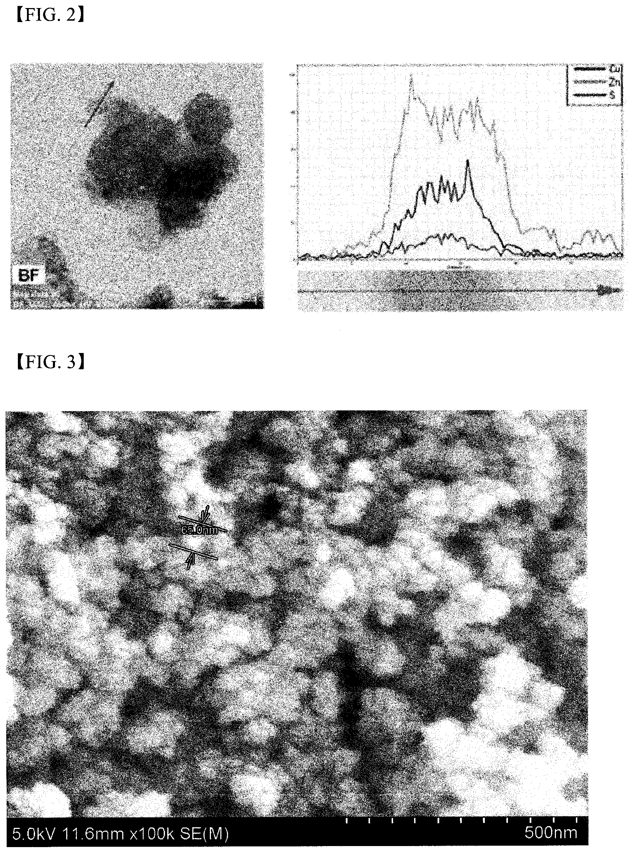

According to the invention, as shown in FIG. 1 and 2, the nanoparticles have two phases uniformly distributed in entire particles or three phases uniformly distributed in entire particles.

The metal chalcogenide nanoparticles manufactured as described above may include a 0.5 to 3 mol of a Group VI element based on a 1 mol of the metal element.

Outside the above range, when too much of the metal element is included, sufficient supply of a Group VI element is impossible and thereby stable phases such as the above metal chalcogenide are not formed and, accordingly, in subsequent processes, phases may be changed or separated metals may be oxidized. On the contrary, when too much of the chalcogenide element is included, a Group VI source is evaporated during a heat treatment process for manufacture of a thin film and thereby a final thin film may have too many pores.

The metal chalcogenide nanoparticles are manufactured according to the method of claim 5.

First, a first precursor including zinc (Zn) or tin (Sn), and sulfur (S) or selenium (Se) is manufactured.

Some zinc (Zn) of the first precursor may be substituted with tin (Sn) and/or copper (Cu) using a reduction potential difference of metals, or some tin (Sn) of the first precursor may be substituted with copper (Cu) using a reduction potential difference of metals.

The manufacturing process of the first precursor includes:
(i) preparing a first solution including at least one a Group VI source selected from the group consisting of compounds including sulfur (S), or selenium (Se), or sulfur (S) and selenium (Se);
(ii) preparing a second solution including a zinc (Zn) salt or tin (Sn) salt; and
(iii) mixing and reacting the first solution and second solution, wherein the first solution and the second solution further comprise a capping agent.

Therefore, the first precursor may be zinc (Zn)-containing chalcogenide or tin (Sn)-containing chalcogenide. Subsequent processes differ depending on the first precursor types.

As one embodiment, when the first precursor is zinc (Zn)-containing chalcogenide, as described above, some zinc (Zn) may be substituted with tin (Sn) and/or copper (Cu) using a reduction potential difference of metals.

Here, zinc (Zn) may be substituted with tin (Sn) and/or copper (Cu) by mixing and reacting a product including zinc (Zn)-containing chalcogenide with a third solution including a tin (Sn) salt or copper (Cu) salt. Here, the zinc (Zn)-containing chalcogenide may be reacted, at the same time, with a tin (Sn) salt and copper (Cu) salt by using a third solution including a tin (Sn) salt and copper (Cu) salt, or may be reacted sequentially with a third solution including a tin (Sn) salt and a fourth solution including a copper (Cu) salt in order of tin and copper. Meanwhile, when the first precursor is tin (Sn)-containing chalcogenide, due to the reduction potential difference of metals, some tin (Sn) may not be substituted with zinc (Zn) and may be substituted with copper (Cu).

Here, tin (Sn) may be substituted with copper (Cu) by mixing and reacting the third solution including a copper (Cu) salt with a product including tin (Sn)-containing chalcogenide.

The above reaction is carried out due to reduction potential differences of zinc, tin, and copper. Concretely, reduction potential order is zinc>tin>copper. The reduction potential may be measurement of electron loss levels. Thus, in solution state, ionization tendency of zinc is greater than that of tin and copper. In addition, ionization tendency of tin is greater than that of copper. Therefore, in zinc (Zn)-containing chalcogenide, zinc may be substituted with tin and copper. In addition, in tin (Sn)-containing chalcogenide, tin may be substituted with copper. However, it is not easy that copper is substitute with tin or zinc, or tin is substituted with zinc.

Meanwhile, in one embodiment, when the first solution and second solution are mixed, the Group VI source may be included in a range of 1 to 10 mol based on 1 mol of the zinc (Zn) salt or tin (Sn) salt.

Outside the range, when the Group VI source is included in a concentration of less than 1 mol, sufficient supply of the Group VI element is impossible and thereby a stable phase such as metal chalcogenide is not obtained in a large yield rate, and, accordingly, the phase may be changed or separated metals may be oxidized in a subsequent process. On the contrary, when the Group VI source is included in a concentration exceeding 10 mol, the Group VI source excessively remains as an impurity after reaction and thereby unevenness of particles may occur. Thus, when a thin film is manufactured with such uneven particles, the Group VI source is evaporated during a heat treatment process of the thin film, and, as such, pores may be excessively formed in a final thin film.

Here, if the second solution mixed with the first solution is reacted at a suitable temperature, zinc (Zn)-containing chalcogenide or tin (Sn)-containing chalcogenide nanoparticles having uniform composition and particle size may be obtained.

In a specific embodiment, solvents for the first solution to fourth solution may be at least one selected from the group consisting of water, alcohols, diethylene glycol (DEG), oleylamine, ethylene glycol, triethylene glycol, dimethyl sulfoxide, dimethyl formamide, and N-methyl-2-pyrrolidone (NMP). In particular, the alchol solvents may be methanol, ethanol, propanol, butanol, pentanol, hexanol, heptanol and octanol having 1 to 8 carbons.

In a specific embodiment, the salt may be at least one salt selected from the group consisting of a chloride, a bromide, an iodide, a nitrate, a nitrite, a sulfate, an acetate, a sulfite, an acetylacetonate and a hydroxide. As the tin (Sn) salt, a divalent or tetravalent salt may be used, but embodiments of the present invention are not limited thereto.

In a specific embodiment, the Group VI source may be at least one salt selected from the group consisting of Se, Na₂Se, K₂Se, CaSe, (CH₃)₂Se, SeO₂, SeCl₄, H₂SeO₃, H₂SeO₄, Na₂S, K₂S, CaS, (CH₃)₂S, H₂SO₄, S, Na₂S₂O₃ and NH₂SO₃H, and hydrates thereof, thiourea, thioacetamide, and selenourea.

Meanwhile, the first solution to fourth solution may further comprise a capping agent.

The capping agent is included during a solution process and, as such, sizes and particle phases of synthesized metal chalcogenide nanoparticles may be controlled.

In addition, since the capping agent prevents condensation of synthesized metal chalcogenide nanoparticles, the third solution or fourth solution may be mixed when synthesized particles are in a uniformly distributed state, and, as such, metals may be uniformly substituted in total particles.

The capping agent is not particularly limited and may, for example, be at least one selected from the group consisting of polyvinylpyrrolidone, sodium L-tartrate dibasic dehydrate, potassium sodium tartrate, sodium acrylate, poly(acrylic acid sodium salt), poly(vinyl pyrrolidone), sodium citrate, trisodium citrate, disodium citrate, sodium gluconate, sodium ascorbate, sorbitol, triethyl phosphate, ethylene diamine, propylene diamine, 1,2-ethanedithiol, and ethanethiol.

The present invention also provides an ink composition according to claim 8 for manufacturing light absorption layers.

In addition, the ink composition may further include bimetallic or intermetallic metal nanoparticles including two or more metals selected from the group consisting of copper (Cu), zinc (Zn) and tin (Sn). Namely, the ink composition may include a mixture of metal chalcogenide nanoparticles including two or more phases and bimetallic or intermetallic metal nanoparticles.

The bimetallic or intermetallic metal nanoparticles may at least one selected from the group consisting of, for example, Cu-Sn bimetallic metal nanoparticles, Cu-Zn bimetallic metal nanoparticles, Sn-Zn bimetallic metal nanoparticles, and Cu-Sn-Zn intermetallic metal nanoparticles.

The inventors of the present invention confirmed that metal nanoparticles of the bimetallic or intermetallic are stable against oxidation, when compared to general metal nanoparticles, and may form a high-density film due to an increase in volume occurring by addition of a Group VI element, in a selenization process through heat treatment. Thus, by using an ink composition manufactured by mixing the bimetallic or intermetallic metal nanoparticles with the metal chalcogenide nanoparticles, film density is improved and the amount of a Group VI element in a final film is increased due to a Group VI element included in an ink composition, resulting in formation of an excellent quality CZTS/Se thin film.

A method of manufacturing the bimetallic or intermetallic metal nanoparticles, which is not limited specifically, may include a solution process using in particular, an organic reducing agent and/or inorganic reducing agent. The reducing agent may be one selected from the group consisting of, for example, LiBH₄, NaBH₄, KBH₄, Ca(BH₄)₂, Mg(BH₄)₂, LiB(Et)₃H, NaBH₃(CN), NaBH(OAc)₃, hydrazine, ascorbic acid and triethanolamine.

Here, the reducing agent may be 1 to 20 times, in a molar ratio, with respect to a total amount of the metal salts included in a solution process.

When the amount of the reducing agent in the metal salts is too small, reduction of the metal salts insufficiently occurs and thus an excessively small size or small amount of intermetallic or bimetallic metal nanoparticles may be obtained or it is difficult to obtain particles having a desired element ratio. In addition, when the amount of the reducing agent exceeds 20 times that of the metal salts, it is not easy to remove the reducing agent and by-products during the purifying process.

The size of the bimetallic or intermetallic metal nanoparticles manufactured according to the above process may be, in particular, approximately 1 to 500 nanometers.

In a specific embodiment, when the bimetallic or intermetallic metal nanoparticles and metal chalcogenide nanoparticles together are dispersed to manufacture an ink composition as described above, the metal nanoparticles and metal chalcogenide nanoparticles are mixed such that all of Cu, Zn, and Sn are included in the ink composition to adjust a composition ratio in a subsequent process. Here, the bimetallic or intermetallic metal nanoparticles and metal chalcogenide nanoparticles are not limited specifically so long as each of Cu, Zn and Sn is included in at least one particle of the metal nanoparticles and metal chalcogenide nanoparticles. In particular, the bimetallic or intermetallic metal nanoparticles may be Cu-Sn bimetallic metal nanoparticles and the metal chalcogenide nanoparticles may be the zinc (Zn)-containing chalcogenide-copper (Cu)-containing chalcogenide nanoparticles including the first phase and third phase. In addition, the bimetallic or intermetallic metal nanoparticles may be Cu-Zn bimetallic metal nanoparticles and the metal chalcogenide nanoparticles may be metal chalcogenide nanoparticles including two phases of the second phase and the third phase. In some cases, Cu-Zn-Sn intermetallic metal nanoparticles may be mixed with metal chalcogenide nanoparticles including the first phase, second phase and third phase.

Here, the Cu-Sn bimetallic nanoparticles may be more particularly CuSn or copper-enriched Cu-Sn particles such as Cu₃Sn, Cu₁₀Sn₃, Cu_{6.26}Sn₅, Cu₄₁Sn₁₁ Cu₆Sn₅ or the like, but the present invention is not limited thereto.

The Cu-Zn bimetallic nanoparticles may be, for example, Cu₅Zn₈, or CuZn.

Of course, when merely a composition ratio of a CZTS thin film is considered, merely the zinc (Zn)-containing chalcogenide nanoparticles or tin (Sn)-containing chalcogenide nanoparticles may be mixed with the metal nanoparticles, the zinc (Zn)-containing chalcogenide nanoparticles and copper (Cu)-containing chalcogenide nanoparticles each independently are synthesized and then mixed each other, or the tin (Sn)-containing chalcogenide nanoparticles and copper (Cu)-containing chalcogenide nanoparticles each independently are synthesized and then mixed each other. However, when sufficient mixing is not carried out during a thin film manufacture process, particles in some areas are respectively separated and thereby heterogeneity of a composition may occur. Such a problem may solved by using the metal chalcogenide nanoparticles according to the present invention including two elements in one particle such as, for example, Cu and Zn, Cu and Sn or the like.

In this case, the bimetallic or intermetallic metal nanoparticles may be mixed with the metal chalcogenide nanoparticles such that the composition of metal in an ink is 0.5≤Cu/(Zn+Sn)≤1.5 and 0.5≤Zn/Sn≤2, preferably 0.7≤Cu/(Zn+Sn)≤1.2 and 8≤Zn/Sn≤1.4 to provide a CZTS final thin film having maximum efficiency.

A method of manufacturing thin film using the ink composition is described.

A method of manufacturing the thin film includes:
(i) preparing an ink (a) by dispersing at least one type of metal chalcogenide nanoparticles including two or more phases selected from the first phase including the zinc (Zn)-containing chalcogenide, the second phase including the tin (Sn)-containing chalcogenide and the third phase including the copper (Cu)-containing chalcogenide, in a solvent, or (b) by dispersing bimetallic or intermetallic metal nanoparticles, and metal chalcogenide nanoparticles including two or more phases selected from the first phase including zinc (Zn)-containing chalcogenide, the second phase including the tin (Sn)-containing chalcogenide and the third phase including the copper (Cu)-containing chalcogenide, in a solvent;
(ii) coating the ink on a base provided with an electrode; and
(iii) drying and then heat-treating the ink coated on the base provided with an electrode.

In the above, the phrase "including at least one type of metal chalcogenide nanoparticles" means including at least one selected from all types of metal chalcogenide nanoparticles, in particular, including all possible combinations selected from zinc (Zn)-containing chalcogenide-tin (Sn)-containing chalcogenide particles including the first phase and second phase, tin (Sn)-containing chalcogenide-copper (Cu)-containing chalcogenide particles including the second phase and the third phase, zinc (Zn)-containing chalcogenide-copper (Cu)-containing chalcogenide particles including the first phase and third phase, and zinc (Zn)-containing chalcogenide-tin (Sn)-containing chalcogenide-copper (Cu)-containing chalcogenide particles including the first phase, the second phase and the third phase.

In addition, embodiments and mix ratios of the bimetallic or intermetallic metal nanoparticles and the metal chalcogenide nanoparticles including two or more phases selected from the first phase including the zinc (Zn)-containing chalcogenide, the second phase including the tin (Sn)-containing chalcogenide and the third phase including the copper (Cu)-containing chalcogenide including are identical to those described above.

In a specific embodiment, the solvent of step (i) is not particularly limited so long as the solvent is a general organic solvent and may be one organic solvent selected from among alkanes, alkenes, alkynes, aromatics, ketones, nitriles, ethers, esters, organic halides, alcohols, amines, thiols, carboxylic acids, phosphines, phosphites, phosphates, sulfoxides, and amides or a mixture of at least one organic solvent selected therefrom.

In particular, the alcohols may be at least one mixed solvent selected from among ethanol, 1-propanol, 2-propanol, 1-pentanol, 2-pentanol, 1-hexanol, 2-hexanol, 3-hexanol, heptanol, octanol, ethylene glycol (EG), diethylene glycol monoethyl ether (DEGMEE), ethylene glycol monomethyl ether (EGMME), ethylene glycol monoethyl ether (EGMEE), ethylene glycol dimethyl ether (EGDME), ethylene glycol diethyl ether (EGDEE), ethylene glycol monopropyl ether (EGMPE), ethylene glycol monobutyl ether (EGMBE), 2-methyl-1-propanol, cyclopentanol, cyclohexanol, propylene glycol propyl ether (PGPE), diethylene glycol dimethyl ether (DEGDME), 1,2-propanediol (1,2-PD), 1,3-propanediol (1,3-PD), 1,4-butanediol (1,4-BD), 1,3-butanediol (1,3-BD), α-terpineol, diethylene glycol (DEG), glycerol, 2-(ethylamino)ethanol, 2-(methylamino)ethanol, and 2-amino-2-methyl-1-propanol.

The amines may be at least one mixed solvent selected from among triethyl amine, dibutyl amine, dipropyl amine, butylamine, ethanolamine, diethylenetriamine (DETA), triethylenetetramine (TETA), triethanolamine, 2-aminoethyl piperazine, 2-hydroxyethyl piperazine, dibutylamine, and tris(2-aminoethyl)amine.

The thiols may be at least one mixed solvent selected from among 1,2-ethanedithiol, pentanethiol, hexanethiol, and mercaptoethanol.

The alkanes may be at least one mixed solvent selected from among hexane, heptane, and octane.

The aromatics may be at least one mixed solvent selected from among toluene, xylene, nitrobenzene, and pyridine.

The organic halides may be at least one mixed solvent selected from among chloroform, methylene chloride, tetrachloromethane, dichloroethane, and chlorobenzene.

The nitriles may be acetonitrile.

The ketones may be at least one mixed solvent selected from among acetone, cyclohexanone, cyclopentanone, and acetyl acetone.

The ethers may be at least one mixed solvent selected from among ethyl ether, tetrahydrofuran, and 1,4-dioxane.

The sulfoxides may be at least one mixed solvent selected from among dimethyl sulfoxide (DMSO) and sulfolane.

The amides may be at least one mixed solvent selected from among dimethyl formamide (DMF) and n-methyl-2-pyrrolidone (NMP).

The esters may be at least one mixed solvent selected from among ethyl lactate, γ-butyrolactone, and ethyl acetoacetate.

The carboxylic acids may be at least one mixed solvent selected from among propionic acid, hexanoic acid, meso-2,3-dimercaptosuccinic acid, thiolactic acid, and thioglycolic acid.

However, the solvents are only given as an example, and embodiments of the present invention are not limited thereto.

In some cases, in preparing of the ink, the ink may be prepared by further adding an additive.

The additive may, for example, be at least one selected from the group consisting of a dispersant, a surfactant, a polymer, a binder, a crosslinking agent, an emulsifying agent, an anti-foaming agent, a drying agent, a filler, a bulking agent, a thickening agent, a film conditioning agent, an antioxidant, a fluidizer, a leveling agent, and a corrosion inhibitor. In particular, the additive may be at least one selected from the group consisting of polyvinylpyrrolidone (PVP), polyvinyl alcohol, Anti-terra 204, Anti-terra 205, ethyl cellulose, and DispersBYK110.

A method of forming a coating layer by coating the ink may, for example, be any one selected from the group consisting of wet coating, spray coating, spin-coating, doctor blade coating, contact printing, top feed reverse printing, bottom feed reverse printing, nozzle feed reverse printing, gravure printing, micro gravure printing, reverse micro gravure printing, roller coating, slot die coating, capillary coating, inkjet-printing, jet deposition, and spray deposition..

The heat treatment of step (iii) may be carried out at a temperature of 300 to 800 °C.

Meanwhile, a selenization process may be included to prepare the thin film of a solar cell having much higher density. The selenization process may be carried out through a variety of methods.

As a first example, effects obtained from the selenization process may be achieved by manufacturing an ink by dispersing S and/or Se to particle types in a solvent with at least one type of metal chalcogenide nanoparticles or bimetallic or intermetallic metal nanoparticles and metal chalcogenide nanoparticles in step (i), and by combining the heat treatment of step (iii).

As a second example, effects obtained from the selenization process may be achieved through the heat treatment of step (iii) in the presence of S or Se

In particular, S or Se may be present by supplying H₂S or H₂Se in a gaseous state or supplying Se or S in a gaseous state through heating.

As a third example, after step (ii), S or Se may be stacked on the coated base, following by performing step (iii). In particular, the stacking process may be performed by a solution process or a deposition method.

A thin film manufactured using the above-described method is disclosed.

The thin film may have a thickness of 0.5 µm to 3.0 µm, more particularly 0.5 µm to 2.5 µm.

When the thickness of the thin film is less than 0.5 µm, the density and amount of the light absorption layer are insufficient and thus desired photoelectric efficiency may not be obtained. On the other hand, when the thickness of the thin film exceeds 3.0 µm, movement distances of carriers increase and, accordingly, there is an increased probability of recombination, which results in reduced efficiency.

A thin film solar cell may be manufactured using the thin film.

A method of manufacturing a thin film solar cell is known in the art and thus a detailed description thereof will be omitted herein.

### [BRIEF DESCRIPTION OF THE DRAWINGS]

The above and other objects, features and other advantages of the present invention will be more clearly understood from the following detailed description taken in conjunction with the accompanying drawing, in which:
FIG. 1 is an image illustrating an EDS mapping result of ZnS-CuS nanoparticles showing uniform compositions of metals substituted with particles synthesized by reduction potential difference and metals substituting according to a comparative example;
FIG. 2 is an image illustrating a line-scan result of ZnS-CuS nanoparticles showing uniform compositions of metals substituted with particles synthesized by reduction potential difference and metals substituting according to a comparative example;
FIG. 3 is a scanning electron microscope (SEM) image of nanoparticles according to Example 1;
FIG. 4 is an X-ray diffraction (XRD) graph of nanoparticles according to Example 1;
FIG. 5 is an SEM image of nanoparticles according to Example 2;
FIG. 6 is an image illustrating EDX analysis of nanoparticles according to Example 2;
FIG. 7 is an XRD graph of nanoparticles according to Example 2;
FIG. 8 is an SEM image of nanoparticles according to Example 3;
FIG. 9 is an SEM image of nanoparticles according to Example 4;
FIG. 10 is an image illustrating an XRD result of nanoparticles according to Example 4;
FIG. 11 is an SEM image of nanoparticles according to Example 5;
FIG. 12 is an SEM image of nanoparticles according to Example 8;
FIG. 13 is an SEM image of nanoparticles according to Example 10;
FIG. 14 is an XRD graph of nanoparticles according to Example 10;
FIG. 15 is an SEM image of a section of a thin film according to Example 12;
FIG. 16 is an XRD graph of a section of a thin film according to Example 12;
FIG. 17 is an SEM image of a section of a thin film according to Example 13; and
FIG. 18 is an IV graph of a solar cell using a thin film of Example 12 according to Experimental Example 1.

### [BEST MODE]

Now, the present invention will be described in more detail with reference to the following examples. Example 1, Example 2, Example 6, Example 10, Example 11, Example 12 and Example 15 are comparative examples, not forming part of the invention.

### <Example 1>

### Synthesis of ZnS-CuS particles

5 mmol of zinc chloride and 10 mmol of Na₂S were respectively dissolved in 50 ml of distilled water 50 ml. The dissolved solutions were mixed and then reacted for 2 hours at room temperature to manufacture ZnS nanoparticles.

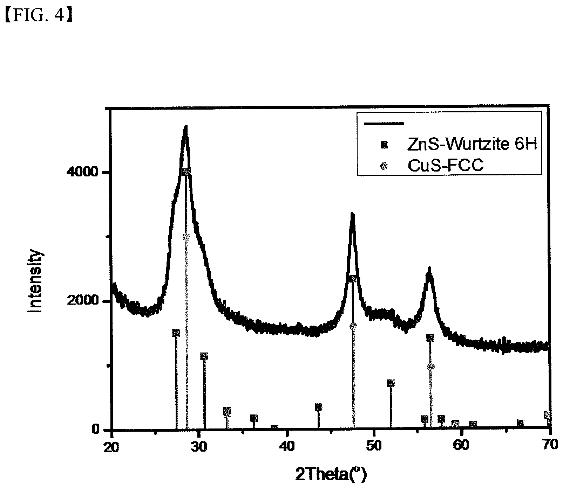

3 mmol of ZnS nanoparticles was dispersed in 30 ml of ethylene glycol (EG) 30 ml and then slowly added dropwise to a 0.6 mmol CuCl₂^{∗}2H₂O solution dissolved in 30 ml of EG while stirring. After stirring for 4 hours, ZnS-CuS particles in which Cu is substituted were obtained by purifying through centrifugation with ethanol. A scanning electron microscope (SEM) image and XRD graph of the formed particles are shown in FIGS. 3 and 4.

It was confirmed that the particles were chalcogenide particles having uniformly distributed Zn and Cu through EDS-mapping and line-scan, as shown in FIGS. 1 and 2.

### <Example 2>

### Synthesis of ZnS-CuS particles

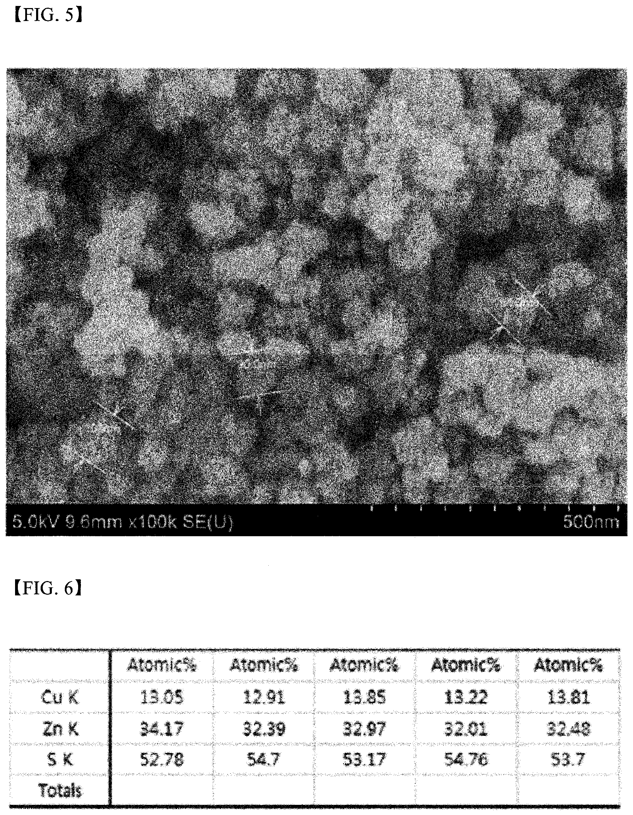

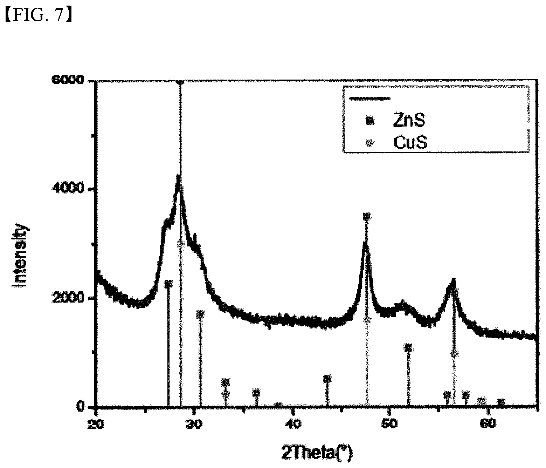

10 mmol of zinc chloride, 20 mmol of thioacetamide, 2mmol of polyvinyl pyrrolidon were dissolved in 200 ml ethylene glycol and then reacted at 180°C for 3 hours. Subsequently, the reacted product was purified through centrifugation, resulting in ZnS particles. The ZnS particles were vacuum-dried and then dispersed in 100 ml of ethylene glycol. Subsequently, 2.5 mmol of CuCl₂·2H₂O dissolved in 50 ml of ethylene glycol was added dropwise to the dispersed product. After reaction for 3 hours, the solution was purified through centrifugation, resulting in ZnS-CuS particles. An SEM image, EDX result, and XRD graph for the formed particles are shown in FIGS. 5 to 7.

### <Example 3>

### Synthesis of ZnS-SnS particles

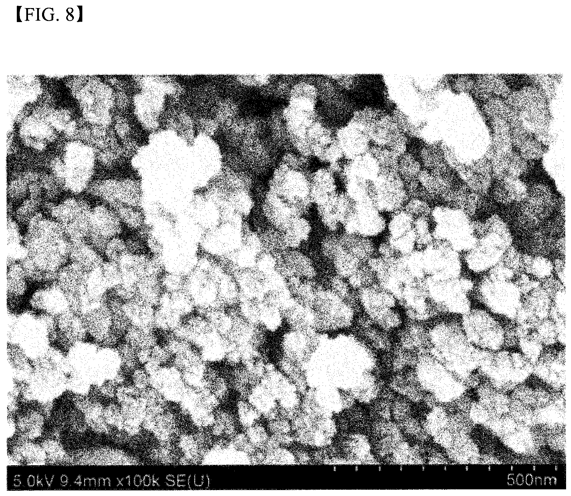

10 mmol of ZnS obtained in the same manner as in Example 2 was dispersed in 200 ml of ethanol and then 2.5 mmol SnCl₄ dissolved in 50 ml of ethanol was added dropwise thereto. The mix solution was stirred for 5 hours at 80 °C and then purified, resulting in ZnS-SnS particles. An SEM image of formed particles is shown in FIG. 8.

### <Example 4>

### Synthesis of SnS-CuS particles

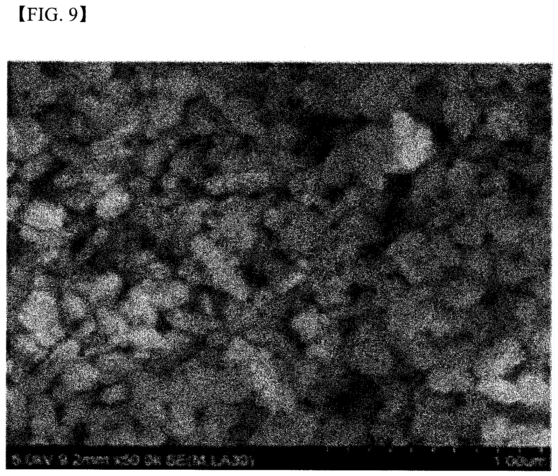

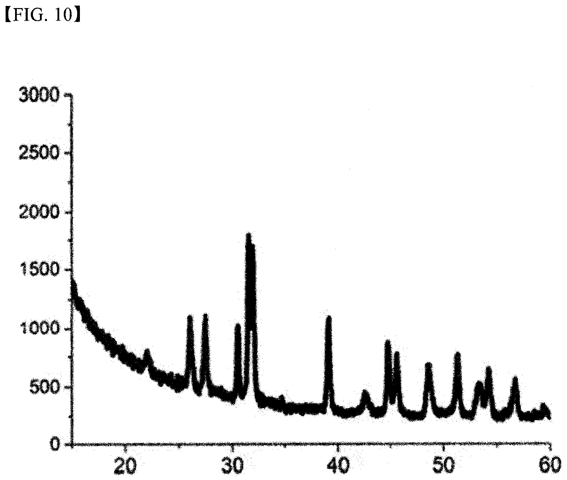

5 mmol of SnCl2, 5 mmol of thioacetamide and 1mmol of polyvinyl pyrrolidon were dissolved in 100 ml of ethylene glycol and then reacted at 108□ for 3 hours. The reacted product was purified through centrifugation, resulting in SnS particles. The SnS particles were dispersed in 100 ml of ethylene glycol 100 ml and then 4 mmol of a CuCl2·2H2O solution was added dropwise thereto. Subsequently, the solution was stirred at 50 °C for 3 hours, resulting in SnS-CuS particles. An SEM image and XRD graph of the formed particles are shown in FIGS. 9 and 10.

### <Example 5>

### Synthesis of ZnS-SnS-CuS particles

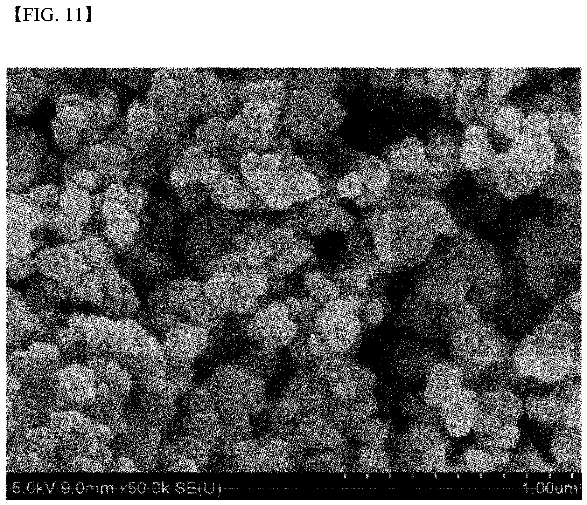

ZnS-SnS particles synthesized in the same manner as in Example 3 were dispersed in 100 ml of ethylene glycol 100 ml and then 4.5 mmol CuCl₂·2H₂O dissolved in ethylene glycol 50 ml was added dropwise thereto. Subsequently, the solution was stirred for 3 hours. As a result, ZnS-SnS-CuS nanoparticles having a ratio of Cu:Zn:Sn=4.5:3:2.5 were obtained. An SEM image for the formed particles is shown in FIG. 11.

### <Example 6>

### Synthesis of ZnSe-CuSe particles

20 mmol of NaBH₄ was dissolved in 50 ml of distilled water and then 10 mmol H₂SeO₃ dissolved in 50 ml of distilled water was added dropwise thereto. After stirring for 20 minutes, 10 mmol ZnCl₂ dissolved in 50 ml of distilled water was slowly added thereto. The resulting solution was stirred for 5 hours and then purified through centrifugation, resulting in ZnSe particles. The obtained particles were dispersed in 100 ml of ethanol and then 2.5 mmol copper acetate dissolved in 50 ml of ethanol was added dropwise thereto, resulting in ZnSe-CuSe particles. As determined by an inductively coupled plasma (ICP) analysis result of the formed particles, a ratio of Cu/Zn was 0.37.

### <Example 7>

### Synthesis of ZnSe-SnSe particles

ZnSe was synthesized in the same manner as in Example 6. Subsequently, obtained particles were dispersed in 100 ml of ethanol and then a 5 mmol tin chloride solution in dissolved 50 ml of ethanol was added dropwise thereto. Subsequently, the resulting solution was stirred at 50°C for 3 hours and then purified through centrifugation, resulting in ZnSe-SnSe particles.

### <Example 8>

### Synthesis of SnSe-CuSe particles

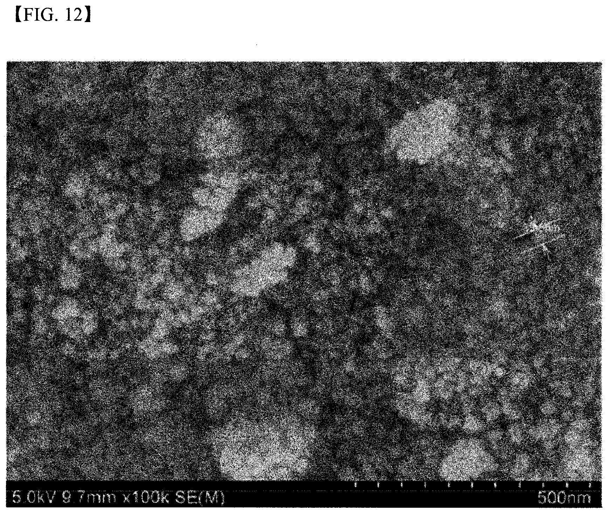

20 mmol of NaBH₄ was dissolved in 50 ml of distilled water and then 10 mmol H₂SeO₃ dissolved in 25 ml of distilled water was added dropwise thereto. After stirring for 20 minutes, 10 mmol ZnCl₂ dissolved in 25 ml of distilled water was added thereto. The resulting solution was reacted for 3 hours and then purified, resulting in SnSe particles. The obtained particles were dispersed in 100 ml of ethanol and then 2.5 mmol CuCl₂·2H₂O dissolved in 50 ml of ethanol was added dropwise thereto. This solution was stirred at 50 °C for 3 hours and then purified, resulting in SnSe-CuSe particles. An SEM image of the formed particles is shown in FIG. 12.

### <Example 9>

### Synthesis of ZnSe-SnSe-CuSe particles

ZnSe-SnSe particles synthesized in the same manner as in Example 7 were dispersed in 100 ml of ethylene glycol 100 ml and then 3 mmol CuCl₂·2H₂O dissolved in 50 ml of ethylene glycol was added dropwise thereto. Subsequently, the solution was stirred for 3.5 hours and then purified through centrifugation. As a result, ZnSe-SnSe-CuSe particles having a ratio of Cu:Zn:Sn=4.5:3:2.4 were obtained.

### <Example 10>

### Synthesis of Cu-Sn particles

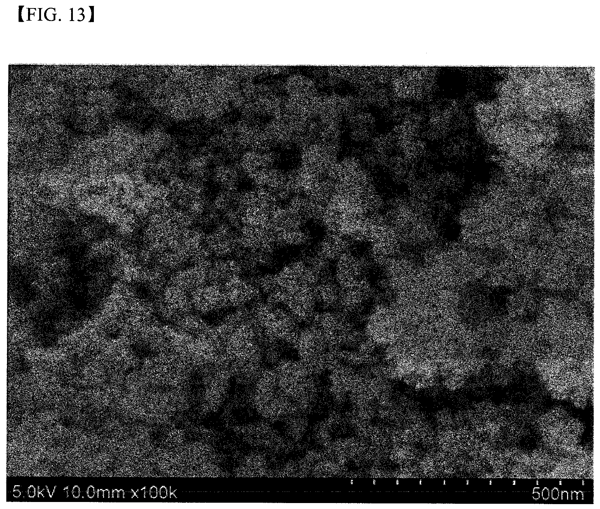

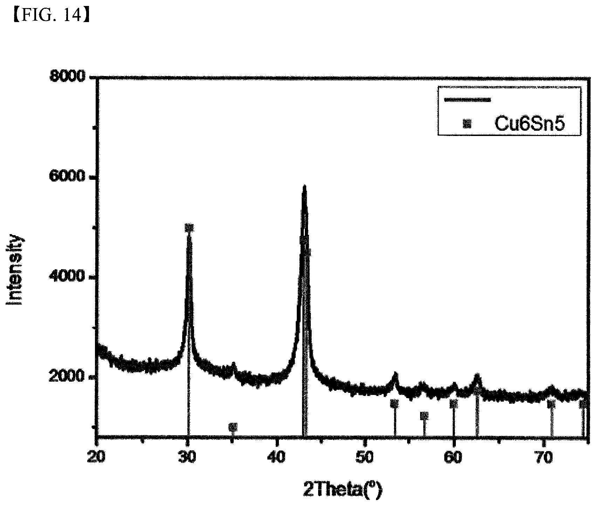

A mixed aqueous solution including 12 mmol CuCl₂, 10 mmol SnCl₂ and 50 mmol trisodium citrate was added over the course of 1 hour to an aqueous solution including 60 mmol NaBH₄ and then reacted while stirring for 24 hours. The formed particles were purified through centrifugation, resulting in Cu₆Sn₅ bimetallic nano particles. An SEM image and XRD graph of the formed particles are shown in FIGS. 13 and 14.

### <Comparative Example 1>

### Synthesis of CuS, ZnS, SnS particles

Each of ZnS and SnS was synthesized in the same manner as in Examples 2 and 4. To manufacture CuS, 10 mmol of Cu(NO₃)₂ and 10 mmol of thioacetamide was respectively dissolved and mixed in two separate ethylene glycol solutions of 50 ml. The resulting two mixture were respectively reacted at 150°C for 3 hours, resulting in CuS particles.

### <Example 11>

### Manufacture of thin film

The ZnS-CuS particles according to Example 1 and the Cu-Sn bimetallic metal particles according to Example 10 were mixed satisfying the following conditions: Cu/(Zn+Sn)=0.9, Zn/Sn=1.24. Subsequently, this mixture was added to a mixed solvent including ethanol, ethylene glycol monomethyl ether, acetylacetone, propylene glycol propyl ether, cyclohexanone and propanol, and then dispersed at a concentration of 18%, so as to manufacture an ink. The obtained ink was coated on a Mo thin film coated on a glass and then dried up to 200 °C. The coated thin film was heat-treated at 550 °C in the presence of Se, resulting in a CZTS thin film.

### <Example 12>

### Manufacture of thin film

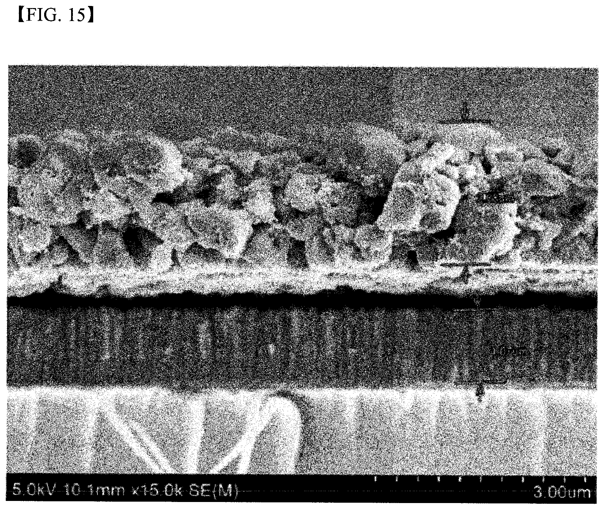

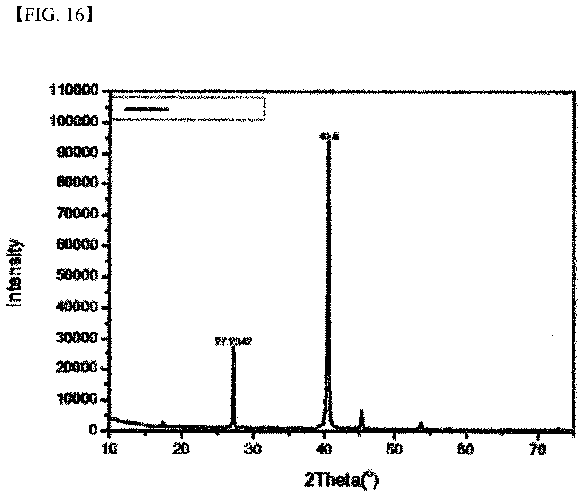

The ZnS-CuS particles according to Example 2 and the Cu-Sn bimetallic metal particles according to Example 10 were mixed satisfying the following conditions: Cu/(Zn+Sn)=0.85, Zn/Sn=1.26. Subsequently, this mixture was added to a mixed solvent including ethanol, ethylene glycol monomethyl ether, acetylacetone, propylene glycol propyl ether, cyclohexanone and propanol, and then dispersed at a concentration of 18%, so as to manufacture an ink. The obtained ink was coated on a Mo thin film coated on glass and then dried up to 200 °C. The coated thin film was heat-treated at 575 °C in the presence of Se, resulting in a CZTS thin film. A section and XRD phase of the obtained thin film are shown in FIGS. 15 and 16.

### <Example 13>

### Manufacture of thin film

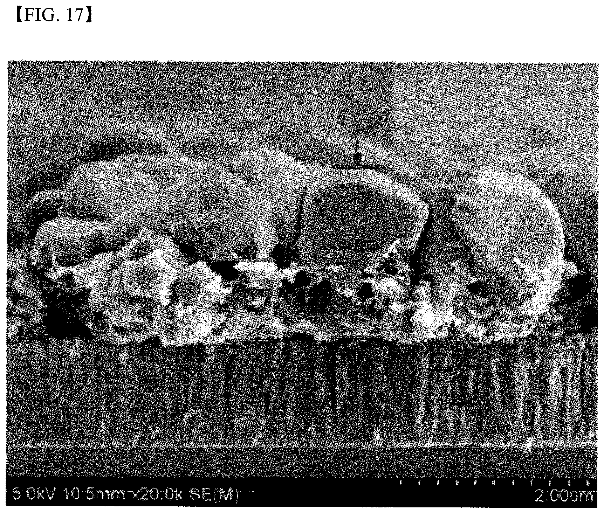

The ZnS-CuS particles according to Example 2 and the SnS-CuS particles according to Example 4 were mixed satisfying the following conditions: Cu/(Zn+Sn)=0.92, Zn/Sn=1.15. Subsequently, this mixture was added to a mixed solvent including ethanol, ethylene glycol monomethyl ether, acetylacetone, propylene glycol propyl ether, cyclohexanone and propanol, and then dispersed at a concentration of 16%, so as to manufacture an ink. The obtained ink was coated on a Mo thin film coated on glass and then dried up to 200 °C. The coated thin film was heat-treated at 575 °C in the presence of Se, resulting in a CZTS thin film. A section of the obtained thin film is shown in FIG. 17.

### <Example 14>

### Manufacture of thin film

The ZnS-SnS-CuS particles according to Example 5 was added to a mixed solvent including ethanol, ethylene glycol monomethyl ether, acetylacetone, propylene glycol propyl ether, cyclohexanone and propanol, and then dispersed at a concentration of 16%, so as to manufacture an ink. The obtained ink was coated on a Mo thin film coated on glass and then dried up to 200 °C. The coated thin film was heat-treated at 575°C in the presence of Se, resulting in a CZTS thin film.

### <Example 15>

### Manufacture of thin film

A CZTS thin film was manufactured in the same manner as in Example 12 except that the ZnSe-CuSe particles manufactured according to Example 6 were mixed with the Cu-Sn bimetallic metal particles manufactured according to Example 10 so as to manufacture an ink.

### <Example 16>

### Manufacture of thin film

A CZTS thin film was manufactured in the same manner as in Example 14 except that the ZnSe-SnSe-CuSe particles manufactured according to Example 9 were used to manufacture an ink.

### <Example 17>

### Manufacture of thin film

A CZTS thin film was manufactured in the same manner as in Example 13 except that the ZnSe-CuSe particles manufactured according to Example 6 were mixed with the SnSe-CuSe particles particles manufactured according to Example 8 so as to manufacture an ink.

### <Example 18>

### Manufacture of thin film

A CZTS thin film was manufactured in the same manner as in Example 13 except that the ZnS-CuS particles manufactured according to Example 2 were mixed with the SnSe-CuSe particles manufactured according to Example 8 so as to manufacture an ink.

### <Comparative Example 2>

### Manufacture of thin film

A CZTS thin film was manufactured in the same manner as in Example 13 except that the CuS particles, ZnS particles, SnS particles manufactured according to Comparative Example 1 were mixed so as to manufacture an ink.

### <Experimental Example 1>

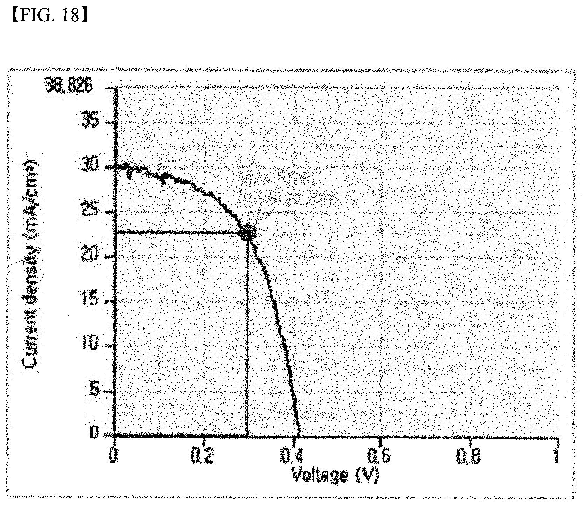

CdS buffer layers were formed by CBD and then ZnO and Al:ZnO were sequentially stacked by sputtering on the CZTS thin films manufactured according to Examples 11 to 18 and Comparative Example 2. Subsequently, Al electrodes were disposed on the thin films by e-beam, completing fabrication of cells. Characteristics of the cells are summarized in Table 1 below and FIG. 18.

**[Table 1]**

| | J_{sc} (mA/cm²) | V_{oc} (V) | FF (%) | Photoelectric efficiency (%) |
|---|---|---|---|---|
| Example 11 | 34.0 | 0.40 | 44.5 | 6.04 |
| Example 12 | 30.24 | 0.41 | 54.7 | 6.8 |
| Example 13 | 33.9 | 0.36 | 40.4 | 4.93 |
| Example 14 | 32.2 | 0.37 | 38.5 | 4.57 |
| Example 15 | 29.34 | 0.38 | 50.5 | 5.63 |
| Example 16 | 29.34 | 0.37 | 38.47 | 4.57 |
| Example 17 | 25.14 | 0.38 | 25.72 | 2.45 |
| Example 18 | 24.2 | 0.37 | 25.7 | 2.30 |
| Comparative Example 2 | 10.0 | 0.32 | 23.8 | 0.75 |

In Table 1, J_{sc}, which is a variable determining the efficiency of each solar cell, represents current density, V_{oc} denotes an open circuit voltage measured at zero output current, the photoelectric efficiency means a rate of cell output according to irradiance of light incident upon a solar cell plate, and fill factor (FF) represents a value obtained by dividing a value obtained by multiplication of current density and voltage values at a maximum power point by a value obtained by multiplication of Voc by J_{sc}.

Referring to Table 1 and FIG. 18, the CZTS thin films manufactured using the metal chalcogenide nanoparticles according to the present invention showed improvement in the current intensity, open circuit voltage, open circuit voltage, and photoelectric efficiency, when compared to nanoparticles manufactured by mixing nanoparticles including the prior only one metal element. Especially, the current intensity and open circuit voltage of the CZTS thin films manufactured using the metal chalcogenide nanoparticles according to the present invention were extremely superior.

### [INDUSTRIAL APPLICABILITY]

As described above, metal chalcogenide nanoparticles according to the present invention include two or more phases selected from a first phase including a zinc (Zn)-containing chalcogenide, a second phase including a tin (Sn)-containing chalcogenide, and a third phase including a copper (Cu)-containing chalcogenide in one particle. When a thin film is manufactured using the metal chalcogenide nanoparticles, one particle includes two or more metals and, as such, the composition of the thin film is entirely uniform. In addition, since nanoparticles include S or Se, the nanoparticles are stable against oxidation. Furthermore, when a thin film is manufactured further including metal nanoparticles, the volumes of particles are extended in a selenization process due to addition of a Group VI element and thereby light absorption layers having high density may grow, and accordingly, the amount of the Group VI element in a final thin film is increased, resulting in a superior quality thin film.

## Claims

1. Metal chalcogenide nanoparticles used for forming light absorption layers of solar cells comprising two phases selected from a first phase comprising a zinc (Zn)-containing chalcogenide, a second phase comprising a tin (Sn)-containing chalcogenide and a third phase comprising a copper (Cu)-containing chalcogenide,
wherein the two phases comprise the first phase and the second phase, or the two phases comprise the second phase and the third phase; and the two phases are uniformly distributed in one metal chalcogenide nanoparticle.

2. The metal chalcogenide nanoparticles according to claim 1, wherein the copper (Cu)-containing chalcogenide is CuₓS wherein 0.5≤x≤2.0, and/or Cu_{y}Se wherein 0.5≤y≤2.0,
wherein the zinc (Zn)-containing chalcogenide is ZnS, and/or ZnSe, and wherein the tin (Sn)-containing chalcogenide is Sn_{z}S wherein 0.5≤z≤2.0 and/or Sn_{w}Se wherein 0.5≤w≤2.0.

3. Metal chalcogenide nanoparticles used for forming light absorption layers of solar cells comprising three phases of a first phase comprising a zinc (Zn)-containing chalcogenide, a second phase comprising a tin (Sn)-containing chalcogenide and a third phase comprising the copper (Cu)-containing chalcogenide, wherein the three phases are uniformly distributed in one metal chalcogenide nanoparticle.

4. The metal chalcogenide nanoparticles according to claim 3, wherein a composition ratio of zinc, tin, and copper comprised in the three phases satisfies the following conditions: 0.5≤Cu/(Zn+Sn)≤1.5 and 0.5≤Zn/Sn≤2.

5. A method of synthesizing the metal chalcogenide nanoparticles according to claim 1 or 3, the method comprising:
manufacturing a first precursor comprising zinc (Zn), and sulfur (S) or selenium (Se), and then some of the zinc (Zn) of the first precursor is substituted with the tin (Sn) by reduction potential differences of metals, or
manufacturing a first precursor comprising tin (Sn), and sulfur (S) or selenium (Se), and then some of the tin (Sn) of the first precursor is substituted with the copper (Cu) by reduction potential differences of metals, or
manufacturing a first precursor comprising zinc (Zn), and sulfur (S) or selenium (Se), and then some of the zinc (Zn) of the first precursor is substituted with the tin (Sn) and the copper (Cu) by reduction potential differences of metals,
wherein the first precursor is manufactured by the method comprising:
(i) preparing a first solution comprising at least one Group VI source selected from the group consisting of compounds comprising sulfur (S), or selenium (Se), or sulfur (S) and selenium (Se);
(ii) preparing a second solution comprising the zinc (Zn) salt or the tin (Sn) salt; and
(iii) mixing and reacting the first solution and the second solution, and
wherein the first solution and the second solution further comprise a capping agent.

6. The method according to claim 5, wherein, to substitute using reduction potential differences of the metals, a product comprising the first precursor is mixed and reacted with a third solution comprising the tin (Sn) salt and/or the copper (Cu) salt.

7. The method according to claim 5, wherein, to substitute some of the zinc (Zn) of the first precursor with the tin (Sn) and the copper (Cu) using reduction potential differences of metals, a product comprising the first precursor is sequentially mixed and reacted with a third solution comprising the tin (Sn) salt and a fourth solution comprising the copper (Cu) salt.

8. An ink composition for manufacturing light absorption layers, wherein the ink composition comprises at least one type of the metal chalcogenide nanoparticles according to claim 1 or 3.

9. The ink composition according to claim 8, further comprising bimetallic or intermetallic metal nanoparticles comprising two or more metals selected from the group consisting of copper (Cu), zinc (Zn) and tin (Sn).

## Patentansprüche

1. Metallchalcogenid-Nanoteilchen, die zur Bildung von Lichtabsorptionsschichten von Solarzellen verwendet werden, enthaltend zwei Phasen, ausgewählt aus einer ersten Phase, enthaltend ein Zink-(Zn)-haltiges Chalcogenid, eine zweite Phase mit einem Zinn-(Sn)-haltigen Chalcogenid und eine dritte Phase mit einem Kupfer-(Cu)-haltigen Chalcogenid, worin die zwei Phasen die erste und die zweite Phase enthalten oder die zwei Phasen die zweite und die dritte Phase enthalten und die zwei Phasen gleichmäßig in einem Metallchalcogenid-Nanoteilchen verteilt sind.

2. Metallchalcogenid-Nanoteilchen gemäß Anspruch 1, worin das Kupfer-(Cu)-haltige Chalcogenid CuₓS ist, worin 0,5≤x≤2,0 und/oder Cu_{y}S ist, worin 0,5≤y≤2,0, worin das Zink(Zn)-haltige Chalcogenid ZnS ist und/oder ZnSe und worin das Zinn-(Sn)-haltige Chalcogenid Sn_{z}S ist, worin 0,5≤z≤2,0 und/oder Sn_{w}Se ist, worin 0,5≤w≤2,0.

3. Metallchalcogenid-Nanoteilchen, verwendet zur Bildung von Lichtabsorptionsschichten von Solarzellen, enthaltend drei Phasen aus einer ersten Phase, enthaltend ein Zink-(Zn)-haltiges Chalcogenid, einer zweiten Phase, enthaltend ein Zinn-(Sn)-haltiges Chalcogenid, und einer dritten Phase, enthaltend das Kupfer-(Cu)-haltige Chalcogenid, worin die drei Phasen gleichmäßig in einem Metallchalcogenid-Nanoteilchen verteilt sind.

4. Metallchalcogenid-Nanoteilchen gemäß Anspruch 3, worin ein Zusammensetzungsverhältnis von Zink, Zinn und Kupfer, die in den drei Phasen enthalten sind, die folgenden Bedingungen erfüllen: 0,5≤Cu/(Zn+Sn)≤1,5 und 0,5≤Zn/Sn≤2.

5. Verfahren zum Synthetisieren der Metallchalcogenid-Nanoteilchen gemäß Anspruch 1 oder 3, wobei das Verfahren enthält:
Herstellen eines ersten Vorläufers, enthaltend Zink (Zn) und Schwefel (S) oder Selen (Se), und wobei dann etwas von dem Zink (Zn) des ersten Vorläufers durch das Zinn (Sn) durch Reduktionspotentialunterschiede von Metallen substituiert wird oder
Herstellen eines ersten Vorläufers, enthaltend Zinn (Sn) und Schwefel (S) oder Selen (Se) und dann wird einiges von dem Zinn (Sn) des ersten Vorläufers mit dem Kupfer (Cu) durch Reduktionspotentialunterschiede von Metallen substituiert oder
Herstellen eines ersten Vorläufers, enthaltend Zink (Zn) und Schwefel (S) oder Selen (Se), und dann wird etwas von dem Zink (Zn) des ersten Vorläufers mit dem Zinn (Sn) und dem Kupfer (Cu) durch Reduktionspotentialunterschiede von Metallen substituiert,
worin der erste Vorläufer durch das Verfahren hergestellt wird, das enthält:
(i) Herstellen einer ersten Lösung, enthaltend zumindest eine Quelle der Gruppe VI, ausgewählt aus der Gruppe, bestehend aus Verbindungen, enthaltend Schwefel (S) oder Selen (Se) oder Schwefel (S) und Selen (SE),
(ii) Herstellen einer zweiten Lösung, enthaltend das Zink-(Zn)-Salz oder das Zinn-(Sn)-Salz und
(iii) Mischen und Reagieren der ersten Lösung und der zweiten Lösung und
worin die erste Lösung und die zweite Lösung weiterhin ein Verschließungsmittel enthalten.

6. Verfahren gemäß Anspruch 5, worin zum Substituieren unter Verwendung von Reduktionspotentialunterschieden der Metalle ein Produkt mit dem ersten Vorläufer mit einer dritten Lösung gemischt und reagiert wird, die das Zinn-(Sn)-Salz oder das Kupfer-(Cu)-Salz enthält.

7. Verfahren gemäß Anspruch 5, worin zum Substituieren von etwas des Zinks (Zn) des ersten Vorläufers mit dem Zinn (Sn) und dem Kupfer (Cu) unter Verwendung von Reduktionspotentialunterschieden von Metallen ein Produkt mit dem ersten Vorläufer aufeinanderfolgend mit einer dritten Lösung, die das Zinn-(Sn)-Salz enthält, und einer vierten Lösung, die das Kupfer-(Cu)-Salz enthält, gemischt und reagiert wird.

8. Tintenzusammensetzung zum Herstellen von Lichtabsorptionsschichten, worin die Tintenzusammensetzung zumindest einen Typ der Metallchalcogenid-Nanoteilchen gemäß Anspruch 1 oder 3 enthält.

9. Tintenzusammensetzung gemäß Anspruch 8, weiterhin enthaltend bimetallische oder intermetallische Metall-Nanoteilchen, enthaltend zwei oder mehrere Metalle, ausgewählt aus der Gruppe, bestehend aus Kupfer (Cu), Zink (Zn) und Zinn (Sn).

## Revendications

1. Nanoparticules de chalcogénure métallique utilisées pour former des couches d'absorption de lumière de cellules solaires comprenant deux phases sélectionnées parmi une première phase comprenant un chalcogénure contenant du zinc (Zn), une deuxième phase comprenant un chalcogénure contenant de l'étain (Sn) et une troisième phase comprenant un chalcogénure contenant du cuivre (Cu),
dans lesquelles les deux phases comprennent la première phase et la deuxième phase, ou
les deux phases comprennent la deuxième phase et la troisième phase ; et
les deux phases sont distribuées uniformément dans une nanoparticule de chalcogénure métallique.

2. Nanoparticules de chalcogénure métallique selon la revendication 1, dans lesquelles le chalcogénure contenant du cuivre (Cu) est CuₓS dans lequel 0,5≤x≤2,0, et/ou Cu_{y}Se dans lequel 0,5≤y≤2,0,
dans lesquelles le chalcogénure contenant du zinc (Zn) est ZnS et/ou ZnSe, et dans lesquelles le chalcogénure contenant de l'étain (Sn) est Sn_{z}S dans lequel 0,5≤z≤2,0 et/ou Sn_{w}Se dans lequel 0,5≤w≤2,0.

3. Nanoparticules de chalcogénure métallique utilisées pour former des couches d'absorption de lumière de cellules solaires comprenant trois phases d'une première phase comprenant un chalcogénure contenant du zinc (Zn), une deuxième phase comprenant un chalcogénure contenant de l'étain (Sn) et une troisième phase comprenant le chalcogénure contenant du cuivre (Cu), dans lesquelles les trois phases sont distribuées uniformément dans une nanoparticule de chalcogénure métallique.

4. Nanoparticules de chalcogénure métallique selon la revendication 3, dans lesquelles un rapport de composition de zinc, d'étain et de cuivre compris dans les trois phases satisfait les conditions suivantes : 0,5≤Cu/(Zn+Sn)≤1,5 et 0,5≤Zn/Sn≤2.

5. Procédé de synthèse des nanoparticules de chalcogénure métallique selon la revendication 1 ou 3, le procédé comprenant les étapes suivantes :
fabriquer un premier précurseur comprenant du zinc (Zn), et du soufre (S) ou du sélénium (Se), puis une partie du zinc (Zn) du premier précurseur est remplacée par l'étain (Sn) par des différences de potentiel de réduction de métaux, ou
fabriquer un premier précurseur comprenant de l'étain (Sn), et du soufre (S) ou du sélénium (Se), puis une partie de l'étain (Sn) du premier précurseur est remplacée par le cuivre (Cu) par des différences de potentiel de réduction de métaux, ou
fabriquer un premier précurseur comprenant du zinc (Zn), et du soufre (S) ou du sélénium (Se), puis une partie du zinc (Zn) du premier précurseur est remplacée par l'étain (Sn) et le cuivre (Cu) par des différences de potentiel de réduction de métaux,
dans lequel le premier précurseur est fabriqué par le procédé comprenant les étapes suivantes :
(i) préparer une première solution comprenant au moins une source du Groupe VI sélectionnée à partir du groupe constitué de composés comprenant du soufre (S), ou du sélénium (Se) ou du soufre (S) et du sélénium (Se) ;
(ii) préparer une deuxième solution comprenant le sel de zinc(Zn) ou le sel d'étain (Sn) ; et
(iii) mélanger et faire réagir la première solution et la deuxième solution, et
dans lequel la première solution et la deuxième solution comprennent en outre un agent de coiffage.

6. Procédé selon la revendication 5, dans lequel, pour substituer l'utilisation de différences de potentiel de réduction des métaux, un produit comprenant le premier précurseur est mélangé et mis à réagir avec une troisième solution comprenant le sel d'étain (Sn) et/ou le sel de cuivre (Cu).

7. Procédé selon la revendication 5, dans lequel, pour substituer une partie du zinc (Zn) du premier précurseur par l'étain (Sn) et le cuivre (Cu) en utilisant des différences de potentiel de réduction des métaux, un produit comprenant le premier précurseur est mélangé séquentiellement et mis à réagir avec une troisième solution comprenant le sel d'étain (Sn) et une quatrième solution comprenant le sel de cuivre (Cu).

8. Composition d'encre pour la fabrication de couches d'absorption de lumière, dans laquelle la composition d'encre comprend au moins un type de nanoparticules de chalcogénure métallique selon la revendication 1 ou 3.

9. Composition d'encre selon la revendication 8, comprenant en outre des nanoparticules métalliques bimétalliques ou intermétalliques comprenant deux métaux ou plus sélectionnés à partir du groupe constitué de cuivre (Cu), de zinc (Zn) et d'étain (Sn).
